# EUROPÄISCHE PATENTANMELDUNG

(11) **EP 2 368 860 A1**
(43) Veröffentlichungstag der Anmeldung: **28.09.2011**
(21) Anmeldenummer: 10154992.1
(22) Anmeldetag: 01.03.2010
(51) Int. Cl.: C03C 17/00, B65G 49/00, C23C 16/54, H01L 31/20, C23C 16/50, C23C 14/50, C23C 14/56

(54) **Vorrichtung und Verfahren zur Substratprozessierung**

(71) Anmelder: Saint-Gobain Glass France, 92400 Courbevoie (FR)
(72) Erfinder: Hartwich, Jessica, 82054 Sauerlach (DE); Karg, Franz, Dr., 80689 München (DE)
(74) Vertreter: Lendvai, Tomas

(57) **Zusammenfassung**

Die vorliegende Erfindung betrifft eine Vorrichtung (1) und ein Verfahren zur Substratprozessierung, wobei zumindest zwei Substrate (11, 11') gleichzeitig in einer im Wesentlichen senkrechten Ausrichtung prozessiert werden, wodurch die Prozessierung der zwei Substrate (11, 11') in einem gemeinsamen Prozessbereich (2) mittels zumindest eines Prozesswerkzeuges (3) gemeinsam erfolgt. Mit der erfindungsgemäßen Vorrichtung (1) und dem erfindungsgemäßen Verfahren eine Substratprozessierung möglich wird, die wesentlich effizienter und kostengünstiger ist und zudem eine sehr homogene Prozessierung ermöglicht.

## Beschreibung

Die vorliegende Erfindung betrifft eine Vorrichtung und ein Verfahren zur Substratprozessierung nach den Oberbegriffen der Ansprüche 1 und 7.

Ein solches Prozessieren wird insbesondere bei der Herstellung von Halbleiterbauelementen vorgenommen und kann unter anderem in einer Beschichtung, Strukturierung, Temperierung oder dgl. bestehen.

Vor allem bei der Prozessierung von Glassubstraten mit passiven und aktiven Komponenten (zum Beispiel für Architekturverglasung, zur Wärmereflektion aus dem Inneren eines Gebäudes, für Displays, Dünnschichtsolarzellen, wie CIS/CIGS-Dünnschichtsolarzellen, oder dgl.) spielen Beschichtungen und Temperaturbehandlungen eine wesentliche Rolle. Beinhaltet die Beschichtung eine flüchtige Komponente (wie z.B. organische Verbindungen, Selen, Schwefel oder dgl.) führt der Beschichtungsprozess, insbesondere aber die Temperaturbehandlung zu einem erheblichen Verlust der flüchtigen Komponente an die Umgebung (wie z.B. die Wände der Beschichtungskammer). Damit kommt es zu einer unkontrollierten Verschiebung der Stöchiometrie der Beschichtung und/oder hohen Zusatzkosten für die Bereitstellung eines erforderlichen Überschusses der flüchtigen Komponente.

Grundsätzlich gelten diese Bedingungen auch für die Prozessierung einer Vielzahl anderer Substratmaterialien, wie Metallplatten, Glaskeramik, Keramik und Kunststoffen.

Zur Kontrolle der Stöchiometrie unter gleichzeitiger Verringerung der Kosten für den erforderlichen Überschuss der flüchtigen Komponente wurde in der WO 2009/135685 eine temporäre Prozessbox vorgeschlagen. Mit Hilfe dieser Prozessbox wird der Prozessraum, in dem das Substrat prozessiert wird, wesentlich verkleinert, so dass zur Erzeugung des notwendigen Partialdruckes an flüchtiger Komponente nur noch eine wesentlich geringere Menge der flüchtigen Komponente bereit gestellt werden muss, wodurch die Kosten bedeutend reduziert werden können.

Die Aufgabe der vorliegenden Erfindung besteht nun darin, diese Kosten weiter zu reduzieren und zugleich eine homogene Prozessierung der Substrate beziehungsweise der Beschichtungen auf den Substraten zu ermöglichen.

Diese Aufgabe wird erfindungsgemäß gelöst mit einer Vorrichtung nach Anspruch 1 sowie dem Verfahren nach Anspruch 7. Vorteilhafte Weiterbildungen sind in den Unteransprüchen angegeben.

Die erfindungsgemäße Vorrichtung zum Prozessieren von Substraten, insbesondere beschichteten Substraten, in einer Prozessierungsanlage, bevorzugt einer Vakuumbehandlungsanlage, mit zumindest einem in zumindest einem Prozessbereich angeordnetem Prozesswerkzeug, insbesondere einer thermischen Verdampfereinrichtung, einer Sputtereinrichtung, bevorzugt einer rotierbaren Zylinder-Magnetron-Sputtereinrichtung, einer Strukturierungseinrichtung, einer Heizeinrichtung oder dgl., zeichnet sich dadurch aus, dass die Vorrichtung in dem Prozessbereich zwei gegenüberliegend angeordnete Substratebenen aufweist, die im Wesentlichen senkrecht ausgerichtet sind, so dass die Vorrichtung angepasst ist, zumindest zwei Substrate gleichzeitig in dem Prozessbereich mit dem Prozesswerkzeug zu prozessieren, wobei die Substrate in den Substratebenen anordenbar sind, wobei die Substratebenen in Bezug auf ihre senkrechte Komponente bevorzugt parallel ausgerichtet sind.

Erfindungsgemäß ist also nunmehr vorgesehen, dass zumindest zwei Substrate gleichzeitig in einer im Wesentlichen senkrechten Ausrichtung prozessiert werden, wodurch die Prozessierung der zwei Substrate in einem gemeinsamen Prozessbereich mittels zumindest eines Prozesswerkzeuges gemeinsam erfolgt.

Dadurch wird im Rahmen eines kombinatorischen Effektes zum einen eine weitgehend spannungs- und verbiegungsfreie Halterung der Substrate ermöglicht. Während bei einer horizontalen Prozessierung, insbesondere auch bei einer solchen Prozessierung mit einer Prozessbox, das Substrat an einer Vielzahl von Auflagepunkten gegenüber Verbiegung abgestützt werden musste, kann bei einer der erfindungsgemäß vorgesehenen vertikalen Prozessierung auf Abstützelemente verzichtet werden, die auf die innere Substratfläche einwirken.

Solche auf die innere Substratfläche einwirkenden Abstützpunkte führen nämlich zum einen lokal zu Spannungen und zum anderen bewirken Sie Abschattungseffekte. Diese Abschattungseffekte entstehen nicht nur bei Beschichtungsvorgängen, sondern vor allem auch bei einer Temperierung, da die Abstützpunkte lokal das Temperaturprofil in dem Substrat verändern.

Dadurch dass nunmehr keine Abstützpunkte mehr an der inneren Substratfläche vorgesehen werden müssen, werden solche Verspannungen und Verbiegungen in dem Substrat verhindert und es treten auch keine Abschattungseffekte mehr auf.

Die zweite vorteilhafte Wirkung der erfindungsgemäßen Ausgestaltung besteht darin, dass in Bezug auf ein Prozesswerkzeug nunmehr zwei Substrate gleichzeitig prozessiert werden, wodurch sich der Durchsatz einer solchen Vakuumbehandlungsanlage verdoppelt, was zu einer bedeutenden Kostenreduzierung führt.

In einer bevorzugten Ausgestaltung ist eine Substrat-Transporteinrichtung vorgesehen, die angepasst ist, die Substrate durch die Vorrichtung an den Prozesswerkzug vorbei zu transportieren. Dann ist die Vorrichtung konstruktiv besonders einfach aufgebaut. Außerdem lässt durch Hintereinanderschaltung mehrerer solcher Vorrichtungen einfach eine In-Line-Vakuumbehandlungsanlage aufbauen, bei der sukzessive viele Substrate in verschiedenen Prozessstationen prozessierbar sind.

Alternativ oder zusätzlich kann allerdings auch vorteilhaft sein, wenn eine Prozesswerkzeug-Transporteinrichtung vorgesehen ist, die angepasst ist, das Prozesswerkzeug durch die Vorrichtung an den Substraten vorbei zu transportieren. Zweckmäßig ist das Prozesswerkzeug zwischen den beiden Substratebenen angeordnet. Dann wirkt es auf beide Substratebenen und die dort befindlichen Substrate gleich und besonders effektiv.

Für eine Heizquelle als Prozesswerkzeug ist allerdings auch möglich, dass sie außerhalb der beiden Substratebenen angeordnet ist. Hierdurch erfolgt eine besonders effektive und schonende Temperierung, da die Heizquelle nicht in unmittelbarer Nähe der Beschichtungen angeordnet werden muss und dennoch vor allem bei dünnen Substraten eine sehr homogene Temperierung erfolgen kann, da jedes Substrat indirekt durch das gegenüberliegende Substrat mit geheizt wird.

Besonders vorteilhaft weisen die Substratebenen, bevorzugt die Substrattransporteinrichtung Wälzkörper auf, die angepasst sind, das Substrat abzustützen, wobei die Wälzkörper bevorzugt nutartig ausgebildet sind, um so einen Führungskanal für das Substrat auszubilden.

Weiterhin kann zweckmäßig zumindest ein Gaseinlass in dem Prozessbereich vorgesehen sein.

In einer bevorzugten Ausgestaltung ist unterhalb der Substratebenen zumindest eine Wanne angeordnet, die bevorzugt aus der Vorrichtung ausziehbar ausgebildet ist. Diese Wanne kann Material auffangen, dass bei einem möglichen Substratbruch entsteht, so dass dieses Material leicht aus der Vorrichtung ausgetragen werden kann.

Selbständiger Schutz wird beansprucht für ein Verfahren zum Prozessieren von Substraten, insbesondere beschichteten Substraten, in einer Prozessierungsanlage, bevorzugt einer Vakuumbehandlungsanlage, mit zumindest einem in zumindest einem Prozessbereich angeordnetem Prozesswerkzeug, insbesondere einer thermischen Verdampfereinrichtung, einer Sputtereinrichtung, bevorzugt einer rotierbaren Zylinder-Magnetron-Sputtereinrichtung, einer Heizeinrichtung oder dgl., dass sich dadurch auszeichnet, dass zumindest zwei Substrate in dem Prozessbereich in gegenüberliegend angeordneten Substratebenen angeordnet werden, wobei die Substratebenen im Wesentlichen senkrecht ausgerichtet sind, wobei die Substratebenen in Bezug auf ihre senkrechte Komponente bevorzugt parallel ausgerichtet sind. Bevorzugt wird dieses Verfahren in einer Vorrichtung nach einem der vorherigen Ansprüche durchgeführt.

Besonders vorteilhaft ist es dann, wenn die Substrate Beschichtungen aufweisen und die Substrate jeweils so gegenüberliegend angeordnet werden, dass die Beschichtungen der Substrate aufeinanderzuweisen. Dadurch wird ein räumlich sehr kleiner Prozessraum definiert.

Diesen Prozessraum kann man bevorzugt dadurch noch weiter verkleinert definieren, dass zumindest während der Prozessierung zwischen den Substraten ein im Wesentlichen geschlossener Prozessraum, insbesondere durch Anordnung eines Rahmens zwischen den Substraten, ausgebildet wird.

In einer zweckmäßigen Ausgestaltung ist vorgesehen, dass zwischen den Substratebenen ein Träger- und/oder Prozessgas eingebracht wird, wobei bevorzugt in dem Rahmen zumindest ein Gaseinlass und zumindest ein Gasauslass vorgesehen werden.

Vorteilhaft werden die Substrate an dem Prozesswerkzeug vorbei bewegt, wobei alternativ oder zusätzlich auch das Prozesswerkzeug an den Substraten vorbei bewegt wird.

Die Merkmale und weitere Vorteile der vorliegenden Erfindung werden nun anhand der Beschreibung von bevorzugten Ausführungsbeispielen unter Bezug auf die Figuren deutlich werden. Dabei zeigen:
- Fig. 1: die erfindungsgemäße Vorrichtung in einer ersten bevorzugten Ausgestaltung und

- Fig. 2: die erfindungsgemäße Vorrichtung in einer zweiten bevorzugten Ausgestaltung.

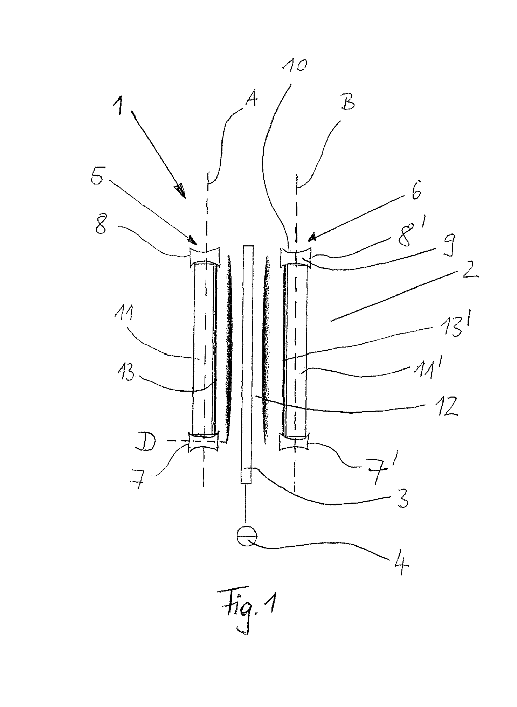

In Fig. 1 ist rein schematisch die erfindungsgemäße Vorrichtung 1 in einer ersten bevorzugten Ausführungsform im Schnitt dargestellt. Die Vorrichtung 1 weist ein nicht weiter dargestelltes evakuierbares Gehäuse auf, in dem mittels geeigneter Pumpentechnik ein bestimmtes Druckniveau einstellbar ist.

In einem Prozessbereich 2 der Vorrichtung 1 ist zumindest ein Prozesswerkzeug 3 angeordnet, das im vorliegenden Fall als rotierbare Zylinder-Magnetron-Sputtereinrichtung 3 ausgebildet ist, die dem Fachmann grundsätzlich bekannt ist. Diese Sputtereinrichtung 3 ist an eine elektrische Versorgungseinrichtung 4 angeschlossen, die sich außerhalb des Gehäuses der Vorrichtung 1 befindet.

Beidseitig der Sputtereinrichtung 3 sind in der Vorrichtung 2 Substrat-Transporteinrichtungen 5, 6 vorgesehen, wobei jede Transporteinrichtung 5, 6 jeweils durch eine untere Reihe 7, 7' und eine obere Reihe 8, 8' von horizontal in einer Ebene angeordneten Wälzkörpern 9 gebildet wird. Dabei sind die untere Reihe 7, 7' und die obere Reihe 8, 8' im Wesentlichen lotrecht übereinander angeordnet, so dass durch die beiden Transporteinrichtungen 5, 6 im Wesentlichen senkrecht verlaufende Substratebenen A, B definiert werden. Die Wälzkörper 9 sind um die Achse D drehbar gelagert und weisen in Bezug auf ihre Längserstreckung entlang der Achse D eine konkave Krümmung auf, wodurch sich ein Führungskanal 10 ausbildet, in dem Substrate 11, 11' angeordnet werden können.

Die Substrate 11, 11' werden über die Wälzkörper 9 in einer Ebene senkrecht zur Darstellungsebene entlang der Substratebenen A, B an der Sputtereinrichtung 3 vorbei transportiert, wobei im Rahmen eines In-Line-Behandlungsverfahrens vor und/oder nach dem Beschichtungsprozess mittels der Sputtereinrichtung 3 sich weitere Prozessierungsschritte anschließen können, beispielsweise Temperierungsschritte und dgl..

Zwischen diesen Substraten 11, 11' ist ein Prozessraum 12 ausgebildet, der seitlich von den Substraten 11, 11' begrenzt wird. Zusätzlich können gegebenenfalls auch obere und untere Begrenzungen, etwa auf Höhe der Wälzkörper 9, zur Begrenzung des Prozessraumes 12 vorgesehen werden. Über geeignete Gaseinlass- und Gasauslasselemente (nicht gezeigt) wird während der Beschichtung ein Prozessgas in den Prozessraum 12 eingelassen, wodurch in dem Prozessraum 12 mittels der Sputtereinrichtung 3 ein Sputterprozess, beispielsweise ein reaktiver Sputterprozess durchgeführt wird, um die Substrate 11, 11' mit einer Beschichtung 13, 13' zu versehen.

Dadurch dass die beiden Substrate 11, 11' mit ihren zu beschichtenden Seiten aufeinander zuweisend angeordnet sind und einen gemeinsamen Prozessraum 12 begrenzen, kann die Beschichtung der Substrate 11, 11' mit der Beschichtung 13, 13' mit einer gemeinsamen Sputtereinrichtung 3 erfolgen, wodurch zum einen der Durchsatz gegenüber Einzelprozessierungslinien verdoppelt wird und zum anderen gegenüber der Verwendung von zwei Sputtereinrichtungen wesentlich weniger Prozessgas notwendig ist. Des Weiteren kann auch auf den Einsatz von Prozessboxen oder dgl. zur Reduzierung des Prozessraumes 12 verzichtet werden, weil die Substrate 11, 11' jetzt selbst den Prozessraum 12 begrenzen.

Durch die Anordnung der Substrate 11, 11' in senkrechten Substratebenen A, B wird zudem erreicht, dass die Substrate 11, 11' keinen abstützungsbedingten Verspannungen und Abschattungseffekten unterliegen. Dadurch erfolgt die Aufbringung der Beschichtung 13, 13' sehr homogen.

Etwaige temperaturbedingte Größenänderungen der Substrate 11, 11' werden über die rotierbaren Wälzkörper 9 abgeführt, so dass es während der Prozessierung nicht zu Verwerfungen der Substrate kommt.

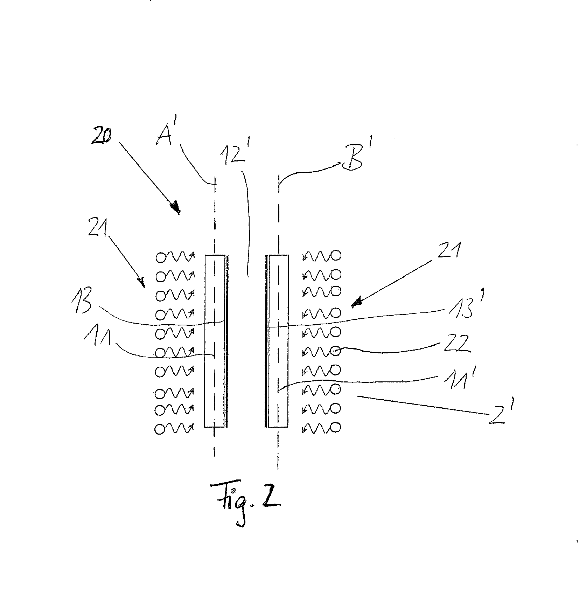

In Fig. 2 ist rein schematisch eine zweite bevorzugte Ausführungsform der erfindungsgemäßen Vorrichtung 20 im Schnitt gezeigt, wobei auch hier wieder die Wandung der Vorrichtung 20 und weitere nicht wesentliche Elemente nicht gezeigt sind. Auch die Substrat-Transporteinrichtung ist hier nicht gezeigt. Dieselben und gleiche Elemente sind dabei mit denselben bzw. gleichen Bezugszeichen versehen.

Zu erkennen ist, dass auch hier wieder mit Beschichtungen 13, 13' versehene Substrate 11, 11' in zwei gegenüberliegend angeordneten Substratebenen A', B' angeordnet sind. Die Substrate sind wiederum mit ihren zu beschichtenden Seiten aufeinander zuweisend ausgerichtet und definieren zwischen sich den Prozessraum 12', in dem vorliegend jedoch kein Beschichtungswerkzeug oder dgl. angeordnet ist. Stattdessen ist der Prozessbereich 2' zum Temperieren eingerichtet, wozu eine Heizquelle 21, bestehend aus zahlreichen Heizelementen 22 vorgesehen ist. Die Heizquelle ist zwar außerhalb der beiden Substratebenen A', B' in zwei Reihen von Heizelementen 22 angeordnet, jedoch handelt es sich um ein einheitliches Prozesswerkzeug 21, da zum einen die Heizelemente 22 gemeinsam betrieben werden und zum anderen die beispielsweise auf das Substrat 11 in der Substratebene A' angeordneten Heizelemente 22 indirekt auch das andere Substrat 11' in der Substratebene B' mit heizen und umgekehrt.

Da bei dieser vorteilhaften Vorrichtung zum Temperieren 20 die Substrate 11, 11' auch wieder aufeinander zuweisend angeordnet sind und einen gemeinsamen Prozessraum 12' begrenzen, ist der Temperierungsprozess sehr effektiv und kostengünstig ausführbar, da zum einen zumindest diese zwei Substrate 11, 11' gleichzeitig temperiert werden können und zum anderen zur Verhinderung eines Ausgasens an flüchtigen Komponenten nur in diesem begrenzten Prozessraum 12' ein Überschuss der flüchtigen Komponente eingebracht werden muss und dieser Überschuss für beide Substrate 11, 11' zugleich verwendet wird.

Der Prozessraum 12' kann zusätzlich dadurch begrenzt werden, dass zwischen den Substraten 11, 11' ein Rahmen (nicht gezeigt) vorgesehen ist, der sich entlang des Umfanges der Substrate 11, 11' erstreckt. Dieser Rahmen kann beispielsweise stationär in der Vorrichtung 20 angeordnet sein, wobei die Substrate 11, 11' in einem sehr geringen Abstand an diesem Rahmen mittels der Substrat-Transporteinrichtung

(nicht gezeigt) vorbeigeführt werden. In diesem Rahmen können dann auch die Gaseinlass- und Gasauslasselemente angeordnet sein.

Während bei den bevorzugten Ausführungsformen stets von einem Vorbeiführen der Substrate 11, 11' an den Prozesswerkzeugen 3, 21 ausgegangen wurde, kann natürlich auch vorgesehen sein, dass die Substrate stationär angeordnet sind und stattdessen die Prozesswerkzeuge an den Substraten vorbeigeführt werden.

Eine weitere Optimierung könnte auch dadurch vorgenommen werden, dass im Rahmen einer In-Line-Vakuumbehandlungsanlage für die Substrate 11, 11' sukzessive durch verschiedene Prozessbereiche 2, 2' geführt werden, wobei dann während der Prozessierung zweier Substrate 11, 11' in beispielsweise einem Beschichtungsbereich das Beschichtungswerkzeug 3 ebenfalls in einer bestimmten Art und Weise innerhalb des Prozessbereiches 2 bewegt wird, um bestimmte zu erzielende Beschichtungsparameter einzustellen.

Die Vorrichtung 1, 20 kann in jeglichen Prozessierungsanlagen eingesetzt werden, wird jedoch bevorzugt in Vakuumbehandlungsanlagen eingesetzt, um eine Behandlung unter besonderen Prozessatmosphären zu ermöglichen. Es kann natürlich auch eine Behandlung und Normaldruck oder sogar unter Überdruck erfolgen, um beispielsweise einen Heizprozess unter besonders angepassten Bedingungen durchzuführen.

Aus der vorstehenden Darstellung ist deutlich geworden, dass mit der erfindungsgemäßen Vorrichtung 1, 21 und dem erfindungsgemäßen Verfahren eine Substratprozessierung möglich wird, die wesentlich effizienter und kostengünstiger ist und zudem eine sehr homogene Prozessierung ermöglicht.

## Patentansprüche

1. Vorrichtung (1, 20) zum Prozessieren von Substraten (11, 11'), insbesondere beschichteten Substraten (11, 11'), in einer Prozessierungsanlage, bevorzugt einer Vakuumbehandlungsanlage, mit zumindest einem in zumindest einem Prozessbereich (2; 2') angeordnetem Prozesswerkzeug (3; 21), insbesondere einer thermischen Verdampfereinrichtung, einer Sputtereinrichtung, bevorzugt einer rotierbaren Zylinder-Magnetron-Sputtereinrichtung (3), einer Strukturierungseinrichtung, einer Heizeinrichtung (21) oder dgl.,
**dadurch gekennzeichnet, dass**
die Vorrichtung (1, 20) in dem Prozessbereich (2; 2') zwei gegenüberliegend angeordnete Substratebenen (A, B; A', B') aufweist, die im Wesentlichen senkrecht ausgerichtet sind, so dass die Vorrichtung (1; 20) angepasst ist, zumindest zwei Substrate (11, 11') gleichzeitig in dem Prozessbereich (2; 2') mit dem Prozesswerkzeug (3; 21) zu prozessieren, wobei die Substrate (11, 11') in den Substratebenen (A, B; A', B') anordenbar sind, wobei die Substratebenen (A, B; A', B') in Bezug auf ihre senkrechte Komponente bevorzugt parallel ausgerichtet sind.

2. Vorrichtung (1; 20) nach Anspruch 1, **dadurch gekennzeichnet, dass** eine Substrat-Transporteinrichtung (5, 6) vorgesehen ist, die angepasst ist, die Substrate (11, 11') durch die Vorrichtung (1; 20) an den Prozesswerkzug (3; 21) vorbei zu transportieren und/oder **dass** eine Prozesswerkzeug-Transporteinrichtung vorgesehen ist, die angepasst ist, das Prozesswerkzeug durch die Vorrichtung an den Substraten vorbei zu transportieren.

3. Vorrichtung (1) nach einem der vorherigen Ansprüche, **dadurch gekennzeichnet, dass** das Prozesswerkzeug (3) zwischen den beiden Substratebenen (A, B) angeordnet ist und/oder **dass** das Prozesswerkzeug eine Heizquelle (21) ist, die außerhalb der beiden Substratebenen (A', B') angeordnet ist.

4. Vorrichtung (1; 20) nach einem der vorherigen Ansprüche, **dadurch gekennzeichnet, dass** die Substratebenen (A, B; A', B'), bevorzugt die Substrattransporteinrichtung (5, 6) Wälzkörper (9) aufweist, die angepasst sind, das Substrat (11, 11') abzustützen, wobei die Wälzkörper (9) bevorzugt nutartig ausgebildet sind, um so einen Führungskanal (10) für das Substrat (11, 11') auszubilden.

5. Vorrichtung nach einem der vorherigen Ansprüche, **dadurch gekennzeichnet, dass** zumindest ein Gaseinlass in dem Prozessbereich vorgesehen ist und/oder dass unterhalb der Substratebenen zumindest eine Wanne angeordnet ist, die bevorzugt aus der Vorrichtung ausziehbar ausgebildet ist.

6. Vorrichtung nach einem der vorherigen Ansprüche, **dadurch gekennzeichnet, dass** zwischen den Substratebenen ein Rahmen angeordnet ist.

7. Verfahren zum Prozessieren von Substraten (11, 11'), insbesondere beschichteten Substraten, in einer Prozessierungsanlage, bevorzugt einer Vakuumbehandlungsanlage, mit zumindest einem in zumindest einem Prozessbereich (2; 2') angeordnetem Prozesswerkzeug (3; 21), insbesondere einer thermischen Verdampfereinrichtung, einer Sputtereinrichtung, bevorzugt einer rotierbaren Zylinder-Magnetron-Sputtereinrichtung (3), einer Heizeinrichtung (21) oder dgl.,
**dadurch gekennzeichnet, dass**
zumindest zwei Substrate (11, 11') in dem Prozessbereich (2; 2') in gegenüberliegend angeordneten Substratebenen (A, B; A', B') angeordnet werden, wobei die Substratebenen (A, B; A', B') im Wesentlichen senkrecht ausgerichtet sind, wobei die Substratebenen (A, B; A', B') in Bezug auf ihre senkrechte Komponente bevorzugt parallel ausgerichtet sind, wobei das Verfahren insbesondere in einer Vorrichtung (1, 20) nach einem der vorherigen Ansprüche durchgeführt wird.

8. Verfahren nach Anspruch 7, **dadurch gekennzeichnet, dass** die Substrate (11, 11') Beschichtungen (13, 13') aufweisen und die Substrate (11, 11') jeweils so gegenüberliegend angeordnet werden, dass die Beschichtungen (13, 13') der Substrate (11, 11') aufeinanderzuweisen, wobei bevorzugt zumindest während der Prozessierung zwischen den Substraten (11, 11') ein im Wesentlichen geschlossener Prozessraum (12; 12'), insbesondere durch Anordnung eines Rahmens zwischen den Substrate, ausgebildet wird.

9. Verfahren nach einem der Ansprüche 7 oder 8, **dadurch gekennzeichnet, dass** zwischen den Substratebenen (A, B; A', B') ein Träger- und/oder Prozessgas eingebracht wird, wobei bevorzugt in dem Rahmen zumindest ein Gaseinlass und zumindest ein Gasauslass vorgesehen werden.

10. Verfahren nach einem der Ansprüche 7 bis 9, **dadurch gekennzeichnet, dass** die Substrate (11, 11') an dem Prozesswerkzeug (3; 21) vorbei bewegt werden und/oder **dass** das Prozesswerkzeug an den Substraten vorbei bewegt wird.
